# EUROPEAN PATENT SPECIFICATION

(11) **EP 3 427 308 B1**
(45) Date of publication and mention of the grant of the patent: **03.04.2024**
(21) Application number: 17707065.3
(22) Date of filing: 01.03.2017
(51) Int. Cl.: H01L 33/56, H01L 25/075, H01L 33/54

(54) **LED MODULE, DEVICE COMPRISING AT LEAST ONE LED MODULE AND A METHOD OF MANUFACTURING LED MODULE**
LED-MODUL, VORRICHTUNG MIT MINDESTENS EINEM LED-MODUL UND VERFAHREN ZUR HERSTELLUNG EINES LED-MODULS
MODULE À DIODE ÉLECTROLUMINESCENTE (DEL), DISPOSITIF COMPRIS D'AU MOINS UN MODULE À DEL ET PROCÉDÉ DE FABRICATION D'UN MODULE À DEL

(30) Priority: 10.03.2016 EP 16159568
(43) Date of publication of application: 16.01.2019
(73) Proprietor: Lumileds LLC, San Jose, CA 95131 (US)
(72) Inventor: CROMPVOETS, Floris, Maria, Hermansz, 52068 Aachen (DE); KLEIJNEN, Christian, 52068 Aachen (DE); SWEEGERS, Norbertus, Antonius, Maria, 52068 Aachen (DE); KUMS, Gerard, 52068 Aachen (DE)
(74) Representative: dompatent von Kreisler Selting Werner - Partnerschaft von Patent- und Rechtsanwälten mbB
(86) International application number: PCT/EP2017/054725
(87) International publication number: WO 2017/153216

(56) References cited:
- EP-A1- 2 448 026
- WO-A1-2015/166022
- WO-A1-2015/179542
- DE-A1-102012 109 144
- US-A1- 2012 087 105

## Description

### FIELD OF THE INVENTION

The invention describes an LED module; a device comprising an LED module; and a method of manufacturing an LED module.

### BACKGROUND OF THE INVENTION

Light-emitting diodes (LEDs) are used in a wide variety of applications.

LED modules of the prior art are disclosed in documents US 2012/087105 A1 and WO 2015/166022 A1.

Specifically, high-power LEDs are finding widespread used in retrofit lamps; in automotive lighting modules such as daytime running lights, brake lights and indicator lights; in smartphone flash units; etc. In some LED lighting applications, the emission surface of the semiconductor die can be seen when the device is turned off. Usually, because of a phosphor coating on the emission surface, the die appears as a small square or rectangle with a yellowish colour. The yellow squares can be very noticeable in some lighting applications such as retrofit lamps in which multiple LEDs are mounted about a rod-shaped insert visible through a glass bulb or plastic tube. Since the visible yellow die may be considered unattractive by the end-user, some LED modules have been developed to make the die less noticeable in the off-state. In a known approach, the LED is coated or encapsulated by a silicone material in which metal oxide particles are suspended. The effect of the metal oxides in the translucent silicone material is to tone down the yellowness of the LED die, thereby giving the LED die a whiter appearance in the off-state. Such LEDs are referred to as "off-state white" LEDs. The addition of the metal oxide particles is generally chosen for spectral and efficiency reasons, but the white colour excludes such LED modules from applications such as automotive brake lights or indicator lights.

In some other applications such as tube LEDs or automotive front and rear lighting units, in which the light source comprises a row of LEDs arranged with a certain pitch (the distance between neighbouring LEDs), the observer generally sees a corresponding row of light "spots" with the same pitch. However, it is generally desirable for the light source to appear homogenous, i.e. as a light strip. In some cases, a diffusing dome might be implemented to eliminate the "spottiness" of the multi-LED light source at the cost of reduced light output. However, this is not always possible or desirable. In an alternative approach, the spottiness can be reduced by severely reducing the LED pitch, placing the LEDs are very close together. An LED light source comprising closely packed LEDs (small pitch) will generally have a more homogenous light output than an LED light source with sparsely packed LEDs (large pitch). However, a small pitch requires additional effort to deal with the resulting thermal issues, and is associated with more complex electrical routing issues. Therefore, an LED light source with small pitch is significantly more expensive to manufacture than a comparable LED light source with large pitch. Particularly in automotive applications, thermal issues and cost are significant factors.

Therefore, it is an object of the invention to provide an improved LED module that overcomes the problems described above.

### SUMMARY OF THE INVENTION

The object of the invention is achieved by the LED module of claim 1; by the device of claim 11; and by the method of claim 12 of manufacturing an LED module.

According to the invention, the LED module comprises an LED arrangement and an encapsulant covering the LED arrangement, which encapsulant is flexible and comprises a mixture of a flexible translucent constituent; and a metallic particle constituent, comprising metallic particles configured to scatter light passing through the encapsulant when the LED module is in an inactive state and when the LED module is in an active state, and to impart a desired colour to the LED module when the LED module is in the inactive state, the weight load of the metallic particles of the metallic particle constituent being in a range between 0.001 wt% and 0.5 wt% of the encapsulant.

An advantage of the LED module according to the invention is that it has a satisfactory off-state appearance since the inherent yellow colour of the diode surface of each LED is hidden. By appropriate choice of the filling mixture constituents, the inventive LED module effectively "hides" the LEDs in the off-state. A further effect of the metallic particle constituent is to diffuse the light in the on-state. Both of these effects are due to the scattering properties of the metallic particle constituent in the encapsulant. The metallic particles, suspended in the encapsulant, scatter the light passing through the encapsulant in both on-state and off-state of the LED module. Furthermore, appropriate choice of the filling mixture constituents allows the off-state colour appearance of the LED module to be matched to a colour in the surroundings of the LED module, e.g. a device housing colour. A desired specific colour of the light emitted by the LED module can be achieved by matching the spectral distribution of the LEDs and the metallic particle constituent to the transmissive spectral properties of the translucent constituent.

According to the invention, the device comprising a device housing and at least one LED module according to any of claims 1 to 10 arranged to emit light through an aperture in the device housing, and wherein the constituents of the encapsulant of the LED modules are chosen to match the colour of the device housing.

An advantage of the device according to the invention is that any LED module embedded in the housing can have a colour that closely matches the device housing. In this way, the device can be imparted with uniform and aesthetically favourable appearance, and the inherently yellow die surfaces of the LEDs are effectively hidden from view during the off-state.

According to the invention, the method of manufacturing an LED module according to claim 12 comprises the steps of providing a container defined by a base and an enclosing wall adjoining the base; arranging a number of LEDs on the base; determining constituents of a encapsulant to impart a desired colour to the LED module when inactive; preparing an encapsulant mixture comprising the flexible translucent constituent and the metallic particle constituent; pouring the encapsulant into the container to cover the LEDs, and subsequently curing the encapsulant, wherein the encapsulant is flexible when cured, wherein the metallic particle constituent comprises metallic particles, wherein relative quantities for translucent constituents and metallic particles are determined to scatter light passing through the encapsulant when the LED module is in an inactive state and when the LED module is in an active state, and to impart a desired colour to the LED module when the LED module is in the inactive state, the weight load of the metallic particles of the metallic particle constituent being in a range between 0.001 wt% and 0.5 wt% of the encapsulant.

An advantage of the inventive method is that an LED module with various favourable optical effects - both in its on-state and in its off-state - can be achieved with relatively little effort and at low cost. The method allows manufacture of an LED module with a favourably homogenous on-state appearance, as desired in automotive applications for example. Equally, the method allows manufacture of an LED module in which the LEDs themselves are hidden or concealed in the off-state, and for which the colour of the LED module can be chosen according to the colour of the device into which the LED module is built.

The dependent claims and the following description disclose particularly advantageous embodiments and features of the invention. Features of the embodiments may be combined as appropriate. Features described in the context of one claim category can apply equally to another claim category. The embodiments of the invention are as defined in the appended claims.

In a particularly preferred embodiment of the invention, the colour of the LED module corresponds to the housing colour of a device that incorporates the LED module. This can be achieved by mixing a quantity of dye into the translucent filler, for example. The quantity of dye may be chosen to make the colour of the translucent filler similar in hue to the colour of the device housing. Such off-state colour matching can be particularly desirable in the case of a device for which aesthetics or optical appearance are significant factors.

There are various possible ways of achieving the desired colour properties. For example, in a preferred embodiment of the invention, the constituents of the encapsulant are chosen to absorb light in one or more specific regions of the visible light spectrum to achieve a specific on-state colour. Preferably, the encapsulant comprises a colour dye constituent.

In a further preferred embodiment of the invention, the LED module comprises an RGBW arrangement of light-emitting diodes, for example an LED strip with red, green, blue and white LEDs in a predefined order. A light engine or LED driver of the LED module can drive the various differently coloured LEDs at the same intensity or at different intensities. A desired specific colour can be achieved by composing a filling mixture with a certain colour; determining suitable intensities for the differently coloured LEDs; and driving them accordingly. Alternatively, assuming that the LEDs will be driven at the same intensity, a desired specific colour can be achieved by composing the filling mixture to absorb certain wavelengths of light.

The translucent constituent of the encapsulant can comprise any suitable material that is transmissive to light and can be used to cover or encapsulate the LEDs in a satisfactory manner. Preferably, the translucent constituent of the encapsulant comprises a transparent material in liquid form that can be mixed with a pigment. An example of such a material is polydimethylsiloxane (PDMS), which can be obtained as a two-component product. When cured, the transparent encapsulant is flexible. This can be advantageous if the LED module is to be removed from the container after curing. For example, the LEDs can be mounted to a carrier such as a flexible band or strip incorporating the electrical connections. After curing, the LEDs are encapsulated in a flexible material, so that the LED module can then be arranged in essentially any shape.

The LEDs of the inventive LED module are effectively "hidden" in the off-state by the inclusion of the metallic particle constituent in the encapsulant. Preferably, the metallic particle constituent is a metal pigment comprising aluminium particles and/or silver particles. These particles are preferably very small, e.g. in the range of 50 - 60 µm, so that they cannot be perceived by the naked eye. The effect of the particles in the encapsulant is to scatter any light passing through the cured, i.e. solidified encapsulant. When the LEDs are off, i.e. the LED module is in the off-state, any ambient light passing through the encapsulant layer is scattered by the metal particles, with the effect of hiding or concealing the yellow surfaces of the LEDs. When the LEDs are on, the particles do not have any significantly detrimental impact on the light output apart from a possible minor lessening of the luminous intensity. However, another favourable effect of the metallic particle constituent - in the case of an LED module with multiple LEDs - is that the "scatter power" of the metallic particle constituent effectively blends the light from the individual LEDs and thereby acts to homogenize the overall light output. In this way, the "spottiness" of a strip of LEDs can be favourably reduced or eliminated, depending on the "scatter power" of the metallic particle constituent in the encapsulant, which is determined by the relative amount of metallic particle constituent and the particle size. In this way, the constituents of the encapsulant impart a desired colour to the LED module when inactive, and also impart a homogenous appearance to the light emitted by the LED module when active. The LED module according to the invention is particularly suited to multi-LED light sources where homogeneity is required in the on-state, for example in an automotive lighting application or in a retrofit LED lamp.

In a further preferred embodiment of the invention, the metallic particle constituent comprises one or more metal oxide pigments such as titanium dioxide (TiO₂), aluminium oxide (Al₂O₃) etc. An encapsulant with such a metallic particle constituent can achieve a uniform light source appearance by reducing or eliminating the spottiness of the LED module.

Preferably, the relative proportions of the encapsulant constituents are chosen under consideration of the pitch of the LEDs of an LED strip, so that the resulting scatter power of the metallic particles achieves the desired light homogeneity for the LED module in the active state.

A single encapsulant is prepared to contain metallic particles and may also contain metal oxide pigments in order to achieve a certain effect. This encapsulant is then poured into the container and cured to encapsulate the LEDs. Alternatively, the LED module can be manufactured in a two-stage process. In a first stage, a first encapsulant comprising metal oxide pigments is prepared, poured into the container to a certain level, and cured. In a second stage, a second encapsulant comprising metallic particles is prepared, poured onto the cured first layer into the container up to a final level, and cured.

The weight load of the metallic particle constituent is determined on the basis of a desired homogeneity of the light generated by the LEDs when active and/or on the basis of a desired sparkling, scintillating or coruscating effect and/or on the basis of a desired degree of concealment of the LEDs when inactive. According to the invention, the weight load of the metallic particles in the metallic particle constituent lies in a range between 0.001 wt% and 0.5 wt% of the encapsulant. A typical weight load of the metallic particles in the metallic particle constituent may be about 0.15 wt% . For example, a "light" composition may comprise metallic flakes to 0.012 wt% in a silicone encapsulant. A "heavy" composition may comprise metallic flakes to 0.014 wt% in a silicone encapsulant.

To achieve a favourably high light output, in a preferred embodiment of the invention the inside surfaces of the enclosing wall of the container are highly reflective. The material of the container can be inherently reflective, depending on the material from which it is made. Alternatively, before installing the LEDs and filling the container with the encapsulant, the inside of the container can be given a highly reflective coating by applying a layer of a suitable material to the inside surfaces. The base of the container and/or the strip to which the LEDs are mounted may also be given a reflective coating or may be made from reflective materials.

Other objects and features of the present invention will become apparent from the following detailed descriptions considered in conjunction with the accompanying drawings. It is to be understood, however, that the drawings are designed solely for the purposes of illustration and not as a definition of the limits of the invention.

### BRIEF DESCRIPTION OF THE DRAWINGS

- Fig. 1: shows a first embodiment of the LED module according to the invention;
- Fig. 2: shows the LED module of Fig. 1 in an off-state;
- Fig. 3: shows the LED module of Fig. 1 in an on-state;
- Fig. 4: is a block diagram illustrating steps of the method according to the invention;
- Fig. 5: shows a stage in the method according to the invention;
- Fig. 6: shows a further embodiment of the LED module according to the invention;
- Fig. 7: shows a prior art LED module.

In the drawings, like numbers refer to like objects throughout. Objects in the diagrams are not necessarily drawn to scale.

### DETAILED DESCRIPTION OF THE EMBODIMENTS

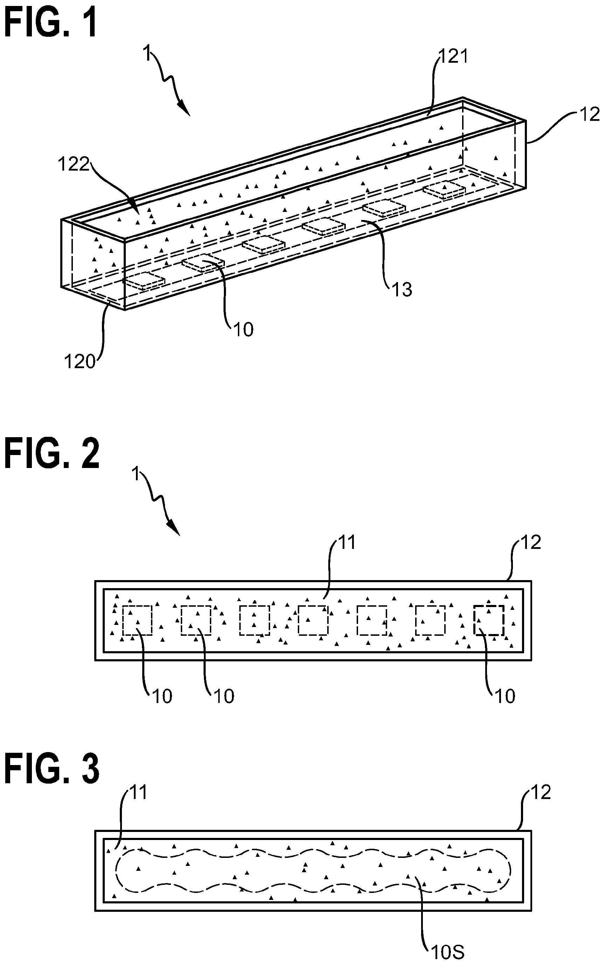

Fig. 1 shows a first embodiment of the LED module 1 according to the invention. The diagram shows a container 12, which serves as a receptacle during the manufacturing process. In this exemplary embodiment, the container 12 has the shape of an elongated rectangle, with a base 120 and side walls 121 that define a light exit opening 122. The diagram shows a row of LEDs 10 mounted onto a band 13 (with the usual electrical connections) arranged along the base 120 of the container 12. The container 12 has been filled with an encapsulant mixture comprising a translucent constituent and a metallic particle constituent (indicated in a greatly exaggerated manner by the small triangle shapes; the particle size is in the micron range). A suitable layer thickness may be in the order of 6 - 7 mm. The mixture has been solidified or cured in a final stage of the manufacturing process to act as the encapsulant 11 for the LEDs 10.

Fig. 2 shows the LED module of Fig. 1 in an off-state. Looking into the container 12, the individual LEDs 10 are effectively hidden or concealed by the scattering action of the metallic particle constituent of the encapsulant 11.

Fig. 3 shows the LED module of Fig. 1 in an on-state. Here, the scattering action of the metallic particle constituent of the encapsulant 11 acts to blend the light originating from the multiple LEDs 10 so that these appear to be a single light source 10S.

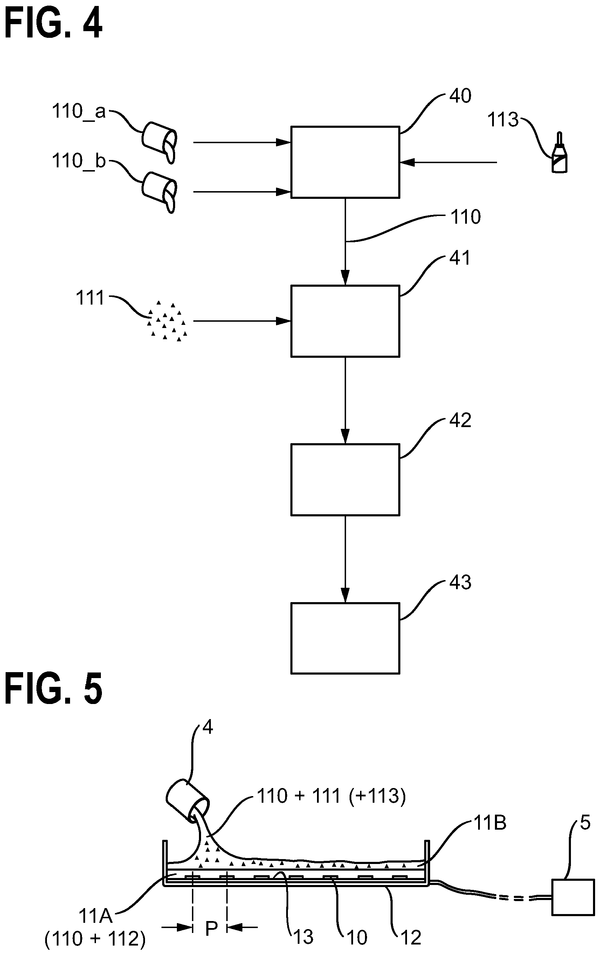

Fig. 4 is a block diagram illustrating steps of the method according to the invention. In step 40, the two components 110_a, 110_b of a translucent encapsulant constituent 110 are mixed thoroughly according to the manufacturer's instructions, for example at 3000 rpm for several minutes. At this stage, a colour dye constituent 113 may also be dissolved in the mixture. In step 41, a metallic particle constituent 111 is added to the translucent constituent 110 and mixed thoroughly, for example at 3000 rpm for several minutes. In step 42, the encapsulant mixture is poured into the container. In step 43, the mixture is cured, for example at 60°C for a several hours.

Fig. 5 shows a stage in the method according to the invention. The diagram shows the carrier 13 to which the LEDs are mounted. This can be a thin flexible band incorporating the necessary electrical connections, and can be connected in the usual manner to an LED driver module 5. Here, the LED module is to be provided with a two-layer encapsulant. To this end, a first encapsulant layer 11A with a translucent constituent 110 and a metal oxide pigment constituent 112 has already been cured. A second layer 11B is being poured from a mixing cup 4 over the first layer 11A. The second layer 11B comprises a translucent constituent 110 and a metallic particle constituent 112, and will be cured in a subsequent step. Of course, the encapsulant 11 can be built up using any number of layers.

This diagram also indicates the pitch P of the LEDs 10. Whether the encapsulant comprises one, two or more layers, the relative quantities of the various constituents 110, 111, 112, 113 are chosen to impart a desired colour to the LED module in the off-state, and to obtain a desired scattering effect so that the LEDs 10 are hidden in their off-state and appear as a single homogenous light source in their on-state, even if the pitch P is large enough to avoid heat-related problems.

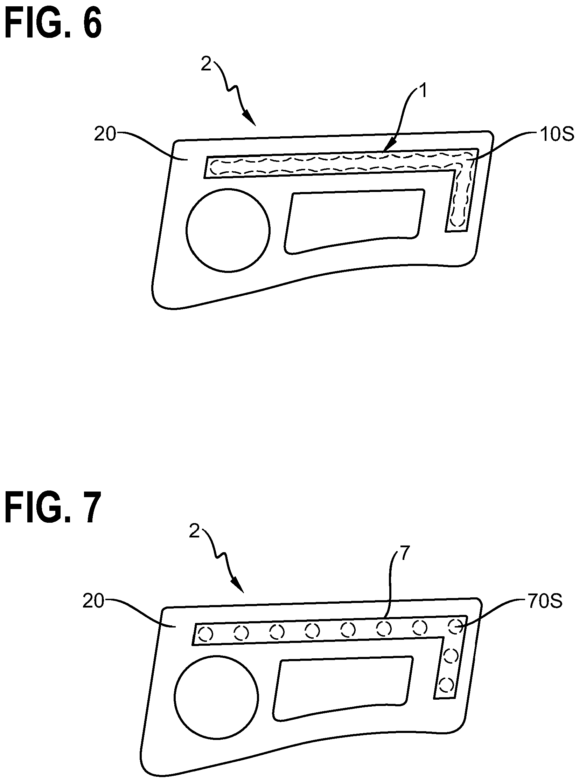

Fig. 6 shows a further embodiment of the LED module 1 according to the invention. Here, the LED module 1 is part of an automotive front lighting arrangement 2 and comprises several LEDs in an L-shaped configuration for daytime running lights. During the on-state of the LED module 1, the light appears to originate from a single light source 10S.

Fig. 7 shows a prior art LED module 7 in a similar automotive front lighting arrangement. Here, during the on-state of the LED module 7, the light from the individual LEDs appears as a series of separate light sources 70S, owing to the pitch between neighbouring LEDs.

Although the present invention has been disclosed in the form of preferred embodiments and variations thereon, it will be understood that numerous additional modifications and variations could be made thereto without departing from the scope of the invention, in as far as they fall within the scope of the appended claims.

For the sake of clarity, it is to be understood that the use of "a" or "an" throughout this application does not exclude a plurality, and "comprising" does not exclude other steps or elements.

### REFERENCE SIGNS:

- 1: LED module
- 10: light-emitting diodes
- 10S: homogenous multi-LED light source
- 11: encapsulant
- 11A, 11B: encapsulant layer
- 110: translucent constituent
- 110_a, 110_b: components of translucent encapsulant
- 111: metallic particle constituent
- 112: metal oxide pigment constituent
- 113: colour dye constituent
- 12: container
- 120: base
- 121: sidewalls
- 122: light exit opening
- 13: carrier

- 2: device
- 4: mixing cup
- 5: driver
- 7: prior art LED module
- 70S: individual light source

- 40, 41, 42, 43: method steps
- P: LED pitch

## Claims

1. An LED module (1) comprising
- a number of light-emitting diodes (10) arranged on a carrier; and
- an encapsulant (11) covering the LEDs (10), which encapsulant (11) is flexible and comprises a mixture of
a flexible translucent constituent (110); and
a metallic particle constituent (111), comprising metallic particles configured to scatter light passing through the encapsulant when the LED module (1) is in an inactive state and when the LED module (1) is in an active state, and to impart a desired colour to the LED module (1) when the LED module (1) is in the inactive state, the weight load of the metallic particles of the metallic particle constituent (111) being in a range between 0.001 wt% and 0.5 wt% of the encapsulant (11).

2. An LED module according to claim 1, wherein, the metallic particle constituent further comprise one or more metal oxide pigments.

3. An LED module according to claim 1, wherein, the metallic particle constituent (111) is configured to have the encapsulant closely match a desired colour in the inactive state of the LED module, in particular a colour of a device (2) that may incorporates the LED module (1).

4. An LED module according to any of the preceding claims, wherein the metallic particle constituent of the encapsulant (11) is chosen to absorb light in one or more specific regions of the visible light spectrum.

5. An LED module according to any of the preceding claims, comprising an RGBW arrangement of light-emitting diodes (10).

6. An LED module according to any of the preceding claims, wherein the translucent constituent (110) of the encapsulant (11) comprises a two-component polydimethylsiloxane.

7. An LED module according to any of the preceding claims, wherein the encapsulant (11) further comprises a colour dye constituent (113).

8. An LED module according to claim 1, wherein the metallic particle constituent is a metal pigment comprising aluminium particles and/or silver particles.

9. An LED module according to any of the preceding claims, wherein the weight load of the metallic particles of the particle constituent (111) is determined on the basis of a desired homogeneity of the light generated by the LEDs (10) when active and/or on the basis of a desired sparkle effect and/or on the basis of a desired degree of concealment of the LEDs when inactive.

10. An LED module according to any of the preceding claims, comprising a container (12) defined by a base (120) along which light-emitting diodes (10) are arranged, and an enclosing wall (121) adjoining the base (12) to form a light exit opening (122).

11. A device (2) comprising a device housing (20) and at least one LED module (1) according to any of claims 1 to 10 arranged to emit light through an aperture in the device housing (2), and wherein constituents (111, 112, 113) of the encapsulant (11) are chosen according to a colour of the device housing (20).

12. A method of manufacturing an LED module (1), comprising the steps of
- providing a container (12) defined by a base (120) and side walls (121);
- arranging a number of LEDs (10) along the base (120) of the container (12);
- determining relative quantities for a flexible translucent constituent (110) and a metallic particle constituent (111) of an encapsulant (11);
- preparing an encapsulant mixture comprising the translucent constituent (110) and the metallic particle constituent (111);
- pouring the encapsulant mixture into the container (12) and subsequently curing the encapsulant (11), wherein the encapsulant (11) is flexible when cured,
wherein the metallic particle constituent (111) comprises metallic particles,
wherein relative quantities for translucent constituents and metallic particles are determined to scatter light passing through the encapsulant when the LED module (1) is in an inactive state and when the LED module (1) is in an active state, and to impart a desired colour to the LED module (1) when the LED module (1) is in the inactive state,
the weight load of the metallic particles of the metallic particle constituent (111) being in a range between 0.001 wt% and 0.5 wt% of the encapsulant (11).

13. A method according to claim 12, comprising the steps of
- pouring a first layer (11A) of an encapsulant mixture into the container (12) to cover the LEDs (10) and subsequently curing the first encapsulant layer (111A);
- pouring a second layer (11B) of an encapsulant mixture into the container (12) to cover the first encapsulant layer (11A), and subsequently curing the second encapsulant layer (11B).

14. A method according to claim 12 or claim 13, comprising a step of determining an LED pitch (P) and/or the relative proportions of the encapsulant constituents (110, 111, 112, 113) on the basis of a desired light homogeneity.

## Patentansprüche

1. LED-Modul (1) mit:
- einer Anzahl von lichtemittierenden Dioden (10), die auf einem Träger angeordnet sind; und
- einem Vergussmaterial (11), das die LEDs (10) bedeckt, wobei das Vergussmaterial (11) felxibel ist und eine Mischung aus
einem flexiblen transluzenten Bestandteil (110) und
einem Metallpartikelbestandteil (111) aufweist, der Metallpartikel aufweist, die dazu ausgebildet sind, das Vergussmittel passierendes Licht zu streuen, wenn sich das LED-Modul (1) in einem inaktiven Zustand befindet und wenn sich das LED-Modul (1) in einem aktiven Zustand befindet, und dem LED-Modul (1) eine gewünschte Farbe zu vermitteln, wenn sich das LED-Modul (1) im inaktiven Zustand befindet, wobei der Gewichtsanteil der Metallpartikel des Metallpartikelbestandteils (111) in einem Bereich zwischen 0,001 Gew.-% und 0,5 Gew.-% des Vergussmaterials (11) liegt.

2. LED-Modul nach Anspruch 1, bei welchem der Metallpartikelbestandteil ferner ein oder mehr Metalloxidpigmente aufweist.

3. LED-Modul nach Anspruch 1, bei welchem der Metallpartikelbestandteil (111) derart ausgebildet ist, dass das Vergussmaterial einer gewünschten Farbe im inaktiven Zustand des LED-Moduls nahekommt, insbesondere einer Farbe einer Vorrichtung (2), welche das LED-Modul (1) aufweist.

4. LED-Modul nach einem der vorhergehenden Ansprüche, bei welchem der Metallpartikelbestandteil des Vergussmaterials (11) so gewählt ist, dass er Licht in einem oder mehr spezifischen Bereichen des sichtbaren Lichtspektrums absorbiert.

5. LED-Modul nach einem der vorhergehenden Ansprüche mit einer RGBW-Anordnung der lichtemittierenden Dioden (10).

6. LED-Modul nach einem der vorhergehenden Ansprüche, bei welchem der transluzente Bestandteil (110) des Vergussmaterials (11) ein Zwei-Komponenten-Polydimethylsiloxan aufweist.

7. LED-Modul nach einem der vorhergehenden Ansprüche, bei welchem das Vergussmaterial (11) ferner einen Farbstoffbestandteil (113) aufweist.

8. LED-Modul nach Anspruch 1, bei welchem der Metallpartikelbestandteil ein Metallpigment ist, welches Aluminiumpartikel und/oder Silberpartikel aufweist.

9. LED-Modul nach einem der vorhergehenden Ansprüche, bei welchem der Gewichtsanteil der Metallpartikel des Partikelbestandteils (111) auf der Basis der gewünschten Homogenität des Lichts, welches von den LEDs (10) erzeugt wird, wenn diese aktiv sind, und/oder auf der Basis eines gewünschten Grades des Verdeckens der LEDs, wenn diese inaktiv sind, ermittelt wird.

10. LED-Modul nach einem der vorhergehenden Ansprüche mit einem Behälter (12), welcher durch eine Basis (120), entlang welcher lichtemittierende Dioden (10) angeordnet sind, und eine umschließende Wand (121) gebildet ist, welche an die Basis (12) angrenzt, um eine Lichtaustrittsöffnung (122) zu bilden.

11. Vorrichtung (1) mit einem Vorrichtungsgehäuse (20) und mindestens einem LED-Modul (1) nach einem der Ansprüche 1 bis 10, das dazu angeordnet ist, Licht durch eine Öffnung in dem Vorrichtungsgehäuse (2) zu emittieren, und wobei Bestandteile (111, 112, 113) des Vergussmittels (11) gemäß einer Farbe des Vorrichtungsgehäuses (20) gewählt sind.

12. Verfahren zur Herstellung eines LED-Moduls (1) mit den folgenden Schritten:
- Bereitstellen eines durch eine Basis (120) und Seitenwände (121) definierten Behälters (12);
- Anordnen einer Anzahl von LEDs (10) entlang der Basis (120) des Behälters (12);
- Ermitteln relativer Mengen für einen flexiblen transluzenten Bestandteil (110) und einen Metallpartikelbestandteil (111) eines Vergussmittels (11);
- Herstellen einer Vergussmaterialmischung, welche den transluzenten Bestandteil (110) und den Metallpartikelbestandteil (111) aufweist;
- Gießen der Vergussmaterialmischung in den Behälter (12) und anschließendes Aushärten des Vergussmaterials (11), wobei das Vergussmaterial (11) flexibel ist, wenn es ausgehärtet ist,
wobei der Metallpartikelbestandteil (111) Metallpartikel aufweist,
wobei relative Mengen für transluzente Bestandteile und Metallpartikel derart bestimmt werden, dass das Vergussmittel passierendes Licht gestreut wird, wenn sich das LED-Modul (1) in einem inaktiven Zustand befindet und wenn sich das LED-Modul (1) in einem aktiven Zustand befindet, und dem LED-Modul (1) eine gewünschte Farbe zu vermitteln, wenn sich das LED-Modul (1) im inaktiven Zustand befindet,
wobei der Gewichtsanteil der Metallpartikel des Metallpartikelbestandteils (111) in einem Bereich zwischen 0,001 Gew.-% und 0,5 Gew.-% des Vergussmaterials (11) liegt.

13. Verfahren nach Anspruch 12 mit den folgenden Schritten:
- Gießen einer ersten Schicht (11A) einer Vergussmaterialmischung in den Behälter (12), um die LEDs (10) zu bedecken, und anschließendes Aushärten der ersten Vergussmaterialschicht (11A);
- Gießen einer zweiten Schicht (11B) einer Vergussmaterialmischung in den Behälter (12), um die erste Vergussmaterialschicht (11A) zu bedecken, und anschließendes Aushärten der zweiten Vergussmaterialschicht (11B).

14. Verfahren nach Anspruch 12 oder Anspruch 13, mit einem Schritt des Bestimmens eines LED-Abstands (P) und/oder der relativen Proportionen der Vergussmaterialbestandteile (110, 111, 112, 113) auf der Basis einer gewünschten Lichthomogenität.

## Revendications

1. Module à DEL (1), comprenant
- un nombre de diodes électroluminescentes (10) agencées sur un support ; et
- un agent d'encapsulation (11) couvrant les DEL (10), lequel agent d'encapsulation (11) est souple et comprend un mélange d'un constituant translucide souple (110) ; et
un constituant de particules métalliques (111), comprenant des particules métalliques conçues pour diffuser la lumière passant à travers l'agent d'encapsulation lorsque le module à DEL (1) est dans un état inactif et lorsque le module à DEL 1) est dans un état actif, et pour communiquer une couleur souhaitée au module à DEL (1) lorsque le module à DEL (1) est dans l'état inactif, le poids des particules métalliques du constituant de particules métalliques (111) se situant dans une plage comprise entre 0,001 % en poids et 0,5 % en poids de l'agent d'encapsulation (11).

2. Module à DEL selon la revendication 1, dans lequel le constituant de particules métalliques comprend en outre un ou plusieurs pigments d'oxyde métallique.

3. Module à DEL selon la revendication 1, dans lequel le constituant de particules métalliques (111 ) est conçu pour avoir l'agent d'encapsulation correspondant étroitement à une couleur souhaitée dans l'état inactif du module à DEL, en particulier une couleur d'un dispositif (2) qui peut incorporer le module à DEL (1).

4. Module à DEL selon l'une quelconque des revendications précédentes, dans lequel le constituant de particules métalliques de l'agent d'encapsulation (11) est choisi pour absorber la lumière dans une ou plusieurs régions spécifiques du spectre de lumière visible.

5. Module à DEL selon l'une quelconque des revendications précédentes, comprenant un agencement RVBB de diodes électroluminescentes (10).

6. Module à DEL selon l'une quelconque des revendications précédentes, dans lequel le constituant translucide (110) de l'agent d'encapsulation (11) comprend un polydiméthylsiloxane à deux composants.

7. Module à DEL selon l'une quelconque des revendications précédentes, dans lequel l'agent d'encapsulation (11) comprend en outre un constituant colorant (113).

8. Module à DEL selon la revendication 1, dans lequel le constituant de particules métalliques est un pigment métallique comprenant des particules d'aluminium et/ou des particules d'argent.

9. Module à DEL selon l'une quelconque des revendications précédentes, dans lequel le poids des particules métalliques du constituant particulaire (111) est déterminée sur la base d'une homogénéité souhaitée de la lumière générée par les DEL (10) lorsqu'elles sont actives et/ou sur la base d'un effet de scintillement souhaité et/ou sur la base d'un degré souhaité d'occultation des DEL lorsqu'elles sont inactives.

10. Module à DEL selon l'une quelconque des revendications précédentes, comprenant un contenant (12) défini par une base (120) le long de laquelle des diodes électroluminescentes (10) sont agencées, et une paroi d'enveloppement (121) adjacente à la base (12) pour former une ouverture de sortie de lumière (122).

11. Dispositif (2) comprenant un boîtier de dispositif (20) et au moins un module à DEL (1) selon l'une quelconque des revendications 1 à 10, agencé pour émettre de la lumière à travers une ouverture dans le boîtier de dispositif (2), et dans lequel des constituants (111, 112, 113) de l'agent d'encapsulation (11) sont choisis selon une couleur du boîtier de dispositif (20).

12. Procédé de fabrication d'un module à DEL (1), comprenant les étapes consistant à
- fournir un contenant (12) défini par une base (120) et des parois latérales (121) ;
- agencer un nombre de DEL (10) le long de la base (120) du contenant (12) ;
- déterminer des quantités relatives pour un constituant translucide souple (110) et un constituant de particules métalliques (111) d'un agent d'encapsulation (11) ;
- préparer un mélange d'agent d'encapsulation comprenant le constituant translucide (110) et le constituant de particules métalliques (111) ;
- verser le mélange d'agent d'encapsulation dans le contenant (12) et durcir ultérieurement l'agent d'encapsulation (11), dans lequel l'agent d'encapsulation (11) est souple lorsqu'il est durci,
dans lequel le constituant de particules métalliques (111) comprend des particules métalliques,
dans lequel des quantités relatives pour des constituants translucides et des particules métalliques sont déterminées pour diffuser la lumière passant à travers l'agent d'encapsulation lorsque le module à DEL (1) est dans un état inactif et lorsque le module à DEL (1) est dans un état actif, et pour communiquer une couleur souhaitée au module à DEL (1) lorsque le module à DEL (1) est dans l'état inactif,
le poids des particules métalliques du constituant de particules métalliques (111) se situant dans une plage comprise entre 0,001 % en poids et 0,5 % en poids de l'agent d'encapsulation (11).

13. Procédé selon la revendication 12, comprenant en outre les étapes consistant à
- verser une première couche (11A) d'un mélange d'agent d'encapsulation dans le contenant (12) pour couvrir les DEL (10) et durcir ultérieurement la première couche d'agent d'encapsulation (11A) ;
- verser une seconde couche (11B) d'un mélange d'agent d'encapsulation dans le contenant (12) pour couvrir la première couche d'agent d'encapsulation (11A), et durcir ultérieurement la seconde couche d'agent d'encapsulation (11B).

14. Procédé selon la revendication 12 ou la revendication 13, comprenant une étape consistant à déterminer un pas de DEL (P) et/ou des proportions relatives des constituants d'agent d'encapsulation (110, 111, 112, 113) sur la base d'une homogénéité de lumière souhaitée.
